# EUROPEAN PATENT SPECIFICATION

(11) **EP 0 568 216 B1**
(45) Date of publication and mention of the grant of the patent: **22.10.1997**
(21) Application number: 93302923.3
(22) Date of filing: 15.04.1993
(51) Int. Cl.: H01L 27/148, H04N 5/217

(54) **Solid-state imaging apparatus**
Festkörperbildaufnahmegerät
Dispositif de prise de vues à l'état solide

(30) Priority: 30.04.1992 JP 135703/92
(43) Date of publication of application: 03.11.1993
(73) Proprietor: SONY CORPORATION, Tokyo 141 (JP)
(72) Inventor: Tomura, Masaharu, c/o Patents Division, Shinagawa-ku, Tokyo 141 (JP); Shimokawa, Kikue, c/o Patents Division, Shinagawa-ku, Tokyo 141 (JP)
(74) Representative: Cotter, Ivan John

(56) References cited:
- US-A- 4 649 430
- PATENT ABSTRACTS OF JAPAN vol. 7, no. 200 (E-196)3 September 1983 & JP-A-58 097 972

## Description

This invention relates to solid-state charge-coupled imaging devices.

In a solid-state imaging device using CCDs (Charge Coupled Devices), in the case of carrying out signal processing for every pixel (cell), e.g., processing such as correction of a defective pixel, or digital shading correction, etc., a timing signal from a timing generator is used as a pixel position reference signal of the solid-state imaging device. Such way of use is carried out in the case of a video camera apparatus of the so-called self-contained system in which a camera control circuit, etc. is included in the camera body.

In the case of a video camera apparatus in which a camera head unit including an optical system and an imaging section, etc. and a camera control unit for controlling the operation are separate, time is taken up in transmission of a video signal between the camera head unit and the camera control unit, giving rise to delay of a video signal. For this reason, it is difficult or impossible simply to use a signal from the timing generator as a pixel position reference signal. Although it is conceivable to take a synchronizing signal as a reference, it is difficult to ensure accuracy as a reference of a pixel unit.

US Patent No. US-A-4 649 430 discloses a solid-state charge-coupled imaging device according to the precharacterising part of claim 1 hereof.

According to the invention there is provided a solid-state charge-coupled imaging device for producing a video signal, the device comprising, on a semiconductor substrate:
an effective pixel region comprising a plurality of effective light receiving pixels having sensor portions for converting incident light to a video signal; and
an optical black region disposed at a peripheral portion of the effective pixel region and comprising a plurality of pixels having sensor portions which are screened by light shielding means;
characterised in that a predetermined pixel within the optical black region is operative to generate a pixel position reference signal, to be output together with the video signal, having a level different from those of output signals of the other pixels of the optical black region.

The invention will now be further described, by way of illustrative and non-limiting example, with reference to the accompanying drawings, in which:
FIG. 1 is a schematic diagram of a solid-state imaging device (also referred to hereinafter as an imaging apparatus) embodying the invention; and
FIG. 2 is a schematic cross sectional view for explaining the structure of a pixel of the solid-state imaging apparatus shown in FIG. 1.

A preferred embodiment of this invention will now be described with reference to the attached drawings.

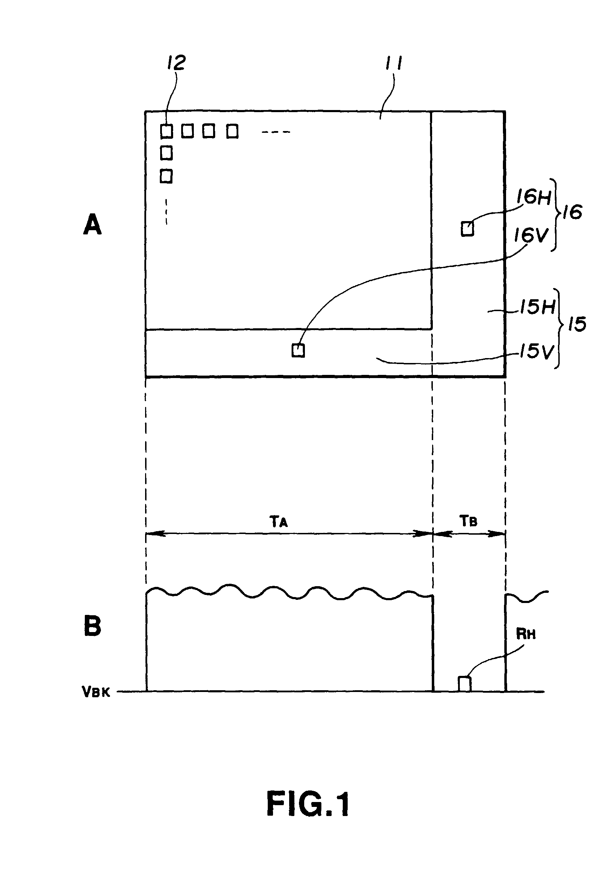

A of FIG. 1 shows the outline of the configuration of an embodiment of a solid-state imaging apparatus according to this invention and B of FIG. 1 is a view for explaining the operation of that apparatus.

Initially, in A of FIG. 1, an effective pixel region 11 is of a structure in which a plurality of pixels 12 are arranged in a two-dimensional matrix form extending lengthwise and breadthwise. In this region 11, light irradiated through a lens system (not shown) is effectively received. Extending over the right side portion 15H in the figure and the lower side portion 15V in the figure around the effective pixel region 11, an optical black region 15 is disposed. This optical black region 15 is such that, e.g., an aluminum film as the light shielding (screening) means is deposited and formed on the surface thereof. In the optical black region 15, no light is received, and a signal of a black level (optical black level) is thus outputted therefrom at all times.

Further, at predetermined positions within the optical black region 15, a predetermined number of position reference pixels 16 to output a signal of a fixed level different from the optical black level are provided. In the example of FIG. 1, a single horizontal position reference pixel 16H is provided at the right side portion 15H within the optical black region 15 and a single vertical position reference pixel 16V is provided at the lower side portion 15V within the same region.

B of FIG. 1 shows an example of an output video signal waveform when lines (scanning lines) including the horizontal position reference pixel 16H are scanned. The time period T_{A} of this waveform corresponds to a time period during which the effective pixel region 11 is scanned, and the time period T_{B} thereof corresponds to a time period during which the right side portion 15H within the optical black region 15 is scanned. A signal for this time period T_{B} has a predetermined optical black level V_{BK}. However, a pulse R_{H} occurring when the horizontal position reference pixel 16H is scanned appears at a level different from the optical black level V_{BK}. Accordingly, this pulse R_{H} is detected, thereby making it possible to use it as a pixel position reference signal.

Since such a pixel position reference signal is obtained by detecting a pulse R_{H} included in a video signal, even if there occurs a delay in the video signal transmission between the camera head unit and the camera control unit, there is not any problem in use as a reference signal, thus making it possible to maintain high accuracy. In this case, the horizontal position reference pixel 16H is used as a position reference in a horizontal direction. Similarly, the vertical position reference pixel 16V may be used as a position reference in a vertical direction.

The above-mentioned position reference pixel 16 may be provided at any position in horizontal and vertical directions within the optical black region 15. In actual terms, at the time of designing a timing generator, etc., coordinates of the position reference pixel may be freely set. In order to output a signal of a fixed level which can be discriminated from the optical black level V_{BK} when the position reference pixel 16 is scanned, there is conceivable a method of removing a light shielding (screening) film such as aluminum, etc. deposited and formed on the pixel 16 to provide a filter, or the like to thereby open a window only in this portion, or to provide a light emitting element for emitting, e.g., an infrared ray, etc. formed on a chip in a manner opposite to the light receiving section (sensor section) of the pixel 16 to carry out shielding by aluminum so that no light is irradiated onto a portion except for the pixel 16. In this case, it is required to design optical black region 15 by taking into consideration transmission, leakage, or diffraction of light, etc.

Further, in the case where a solid-state imaging apparatus described in "High Sensitivity Interline type CCD of minimum illuminance 51x" Nikkei Micro Device, October, 1987, pp 60-67 is used as a solid-state imaging apparatus (solid-state imaging device), it is also preferable to adopt a configuration to increase a dark current (dark current quantity) from the light receiving section (sensor section) of the pixel by allowing the surface state to be in correspondence with a depleted state only at portion of the position reference pixel 16.

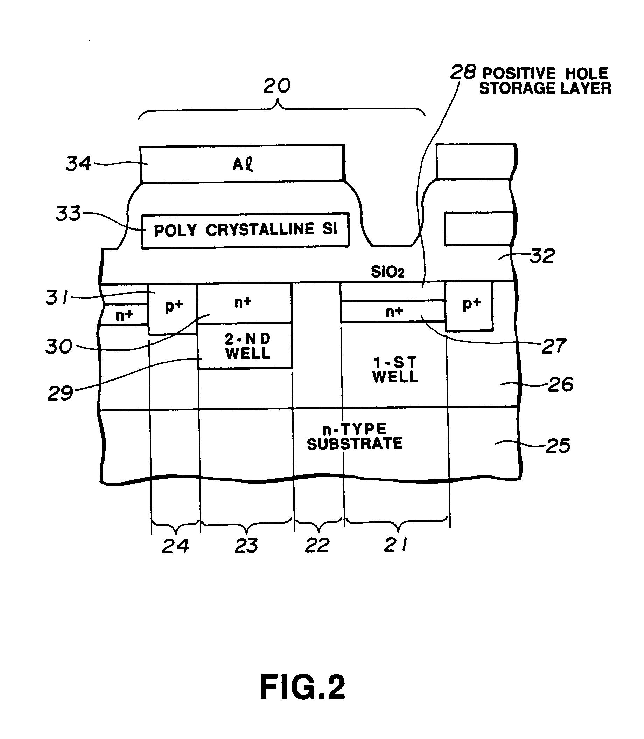

The solid-state imaging device described in the above-mentioned literature will now be briefly described. This device is adapted to store positive holes on the surface of a substrate to thereby suppress a dark current. The structure of this device is shown in FIG. 2. In FIG. 2, a single pixel 20 is comprised of a light receiving section (sensor section) 21, a readout gate 22, a vertical register 23, and a channel stopper 24. A (first) p-well region 26 is formed on an n-type silicon substrate 25. An n⁺ region 27 is formed at the sensor section 21 within the p-well region 26. Further, a positive hole storage layer 28 is formed so as to face to the surface of the n⁺ region 27. In the vertical register 23, a second p-well region 29 is formed within the (first) p-well region 26. In addition, an n⁺ region 30 is formed so as to face to the surface on the second p-well region 29. The channel stopper 24 is comprised of a p⁺ region 31 formed so as to face to the surface of the p-well region 26. On these surfaces, a SiO₂ film 32 as an insulating layer is deposited and formed. A polycrystalline Si layer 33 serving as an electrode is formed so as to cover the readout gate 22, the vertical register 23 and the channel stopper 24 through the above-mentioned insulating layer (SiO₂ film 32). Further, an Aℓ (aluminum) layer 34 serving as a light shielding (screening) film is deposited and formed through an insulating layer such as SiO₂, etc. The Aℓ layer 34 portion on the sensor section 21 is removed. Thus, a light can be received through the transparent polycrystalline Si layer 33.

Here, in general solid-state imaging devices, whether the sensitivity is high or low is of a problem in the case where imaging is carried out at a low illuminance. By taking into consideration the fact that a fixed pattern noise by a dark current is dominant rather than light shot noise in this case, in the solid-state imaging device including the pixel of the structure shown in FIG. 2, the absolute value of a dark current is reduced to improve the sensitivity. This dark current includes, as a main component, a diffusion current caused to flow into the pixel from the substrate or the neutral region, a current produced resulting from the surface state of a sensor surface, and a current produced resulting from a surface state of a vertical register surface. In order to first reduce a current component (electrons) caused to flow into the pixel by diffusion from the substrate, p-well region 26 is formed on n-type substrate 25 to allow particularly the p-well region 26 to be operative in a depleted state, thus to substantially completely suppress the diffusion component from the neutral region. With respect to a current produced on the sensor surface, positive hole storage layer 28 is provided to allow positive holes to be in a storage state to suppress such a current. A dark current produced from the vertical register surface is also suppressed on the basis of the principle similar to the above. Positive holes are stored on the surface by a voltage applied to the gate electrode (the polycrystalline Si layer 33), thus to reduce the absolute value of a dark current produced from the surface of the vertical register 23.

Pixels of such a structure are disposed in the effective pixel region 11 of FIG. 1 and pixels of the structure in which a light shielding (screening) Aℓ layer 34 is provided also on the sensor portion 21 (i.e., such layer 34 is left without being removed) are disposed in the optical black region 15. By allowing the surface state of the sensor portion 21 to be in correspondence with a depleted state only at the portions of the position reference pixels 16 (horizontal and vertical position reference pixels 16H, 16V), a dark current at this portion is caused to be larger than those at other portions so that a signal of a fixed level is obtained with respect to the optical black level V_{BK}. Thus, this signal can be detected as a pixel position reference signal.

In accordance with the embodiment of the solid-state imaging apparatus which has been described, even in the case where a timing signal from a timing generator cannot be used as a pixel position reference signal for signal processing every pixel with respect to a video signal cannot be used because of delay due to the fact that transmission of a video signal is carried out between the camera head unit and the camera control unit which are separated, the position reference signals included in a video signal, i.e., signals obtained by detecting the position reference pixels 16 (horizontal and vertical position reference pixels 16H, 16V) can be used as a pixel position reference signal. Accordingly, signal processing every pixel can be realized without undergoing the influence of a delay followed by transmission of a video signal.

It should be noted that this invention is not limited only to the above-described embodiment. For example, only one position reference pixel, or three position reference pixels or more may be provided. In addition, the coordinates of the position reference pixel can be arbitrarily set at the time of design of a camera system or a timing generator, etc.

As is clear from the foregoing description, in accordance with the video camera apparatus embodying this invention, since a position reference pixel to produce an output signal different from output signals of other pixels in the optical black region is provided at a predetermined position within the optical black region at the peripheral portion of the effective pixel region, it is possible to detect, from an image pickup video output signal, a signal occurring when the position reference pixel is scanned. Further, this signal is used as a pixel position reference signal in implementing signal processing every pixel to a video signal, thereby making it possible to realize a signal processing by a higher accuracy pixel position reference without undergoing the influence of a delay, etc. at the time of transmission of a video signal.

## Claims

1. A solid-state charge-coupled imaging device for producing a video signal, the device comprising, on a semiconductor substrate (25):
an effective pixel region (11) comprising a plurality of effective light receiving pixels (12, 20) having sensor portions (21) for converting incident light to a video signal; and
an optical black region (15) disposed at a peripheral portion of the effective pixel region (11) and comprising a plurality of pixels (20) having sensor portions which are screened by light shielding means (34);
characterised in that a predetermined pixel (16) within the optical black region (15) is operative to generate a pixel position reference signal, to be output together with the video signal, having a level different from those of output signals of the other pixels of the optical black region (15).

2. A solid-state charge-coupled imaging device according to claim 1, wherein said light shielding means (34) includes an opening at a position corresponding to said predetermined pixel (16) within the optical black region (15).

3. A solid-state charge-coupled imaging device according to claim 1, wherein a light emitting means is positioned between said light shielding means and said pixels and is operative to irradiate with light said predetermined pixel (16) within the optical black region (15).

4. A solid-state charge-coupled imaging device according to claim 1, wherein the magnitude of a dark current produced by said predetermined pixel (16) within the optical black region (15) is caused to be larger than the magnitude of dark currents produced by the other pixels of the optical black region by allowing a depleted surface state of the sensor portion (21) for said predetermined pixel only.

## Patentansprüche

1. Ladungsgekoppeltes Festkörperabbildgerät zur Erzeugung eines Videosignals, wobei das Gerät auf einem Halbleiter-Substrat (25) aufweist:
einen wirksamen Pixelbereich (11), der mehrere wirksame Lichtempfangspixel (12, 20) besitzt, die Sensorbereiche (21) haben, um einfallendes Licht in ein Videosignal umzusetzen; und
einen optisch schwarzen Bereich (15), der an einem peripheren Bereich des wirksamen Pixelbereichs (11) angeordnet ist und mehrere Pixel (20) umfaßt, die Sensorbereiche haben, die durch Lichtabschirmmittel (34) abgeschirmt sind;
**dadurch gekennzeichnet, daß**
ein bestimmtes Pixel (16) innerhalb des optisch schwarzen Bereichs (15) ein Pixelpositionsreferenzsignal erzeugen kann, welches zusammen mit dem Videosignal ausgegeben wird, welches einen Pegel hat, der sich von denen der Ausgangssignale der anderen Pixel des optisch schwarzen Bereichs (15) unterscheidet.

2. Ladungsgekoppeltes Festkörperabbildgerät nach Anspruch 1, wobei die Lichtabschirmeinrichtung (34) eine Öffnung an einer Position besitzt, die dem vorgegebenen Pixel (16) innerhalb des optisch schwarzen Bereichs (15) entspricht.

3. Ladungsgekoppelte Festkörperabbildeinrichtung nach Anspruch 1, wobei eine Lichtemittiereinrichtung zwischen der Lichtabschirmeinrichtung und den Pixeln angeordnet ist und mit Licht das vorgegebene Pixel (16) innerhalb des optisch schwarzen Bereichs (15) bestrahlen kann.

4. Ladungsgekoppeltes Festkörperabbildgerät nach Anspruch 1, wobei die Größe eines Dunkelstroms, der durch das vorgegebene Pixel (16) innerhalb des optisch schwarzen Bereichs (15) erzeugt wird, veranlaßt wird, daß diese größer ist als die Größe der Dunkelströme, die durch die anderen Pixel des optisch schwarzen Bereichs erzeugt werden, wobei ein verarmter Oberflächenzustand des Sensorbereichs (21) nur für dieses vorgegebene Pixel erlaubt wird.

## Revendications

1. Dispositif d'imagerie à couplage de charge à semi-conducteur pour la production d'un signal vidéo, dispositif comprenant sur un support de semi-conducteur (25) :
- une zone effective de pixel (11) comprenant une pluralité de pixels efficaces de réception de la lumière (12, 20) possédant des parties de capteur (21) pour la conversion d'une lumière incidente en un signal vidéo; et
- une zone d'occultation optique (15) placée sur une partie de périphérie de la zone effective de pixel (11) et comprenant une pluralité de pixels (20) possédant des parties de capteur qui sont occultées par un moyen d'occultation de la lumière (34);
dispositif caractérisé en ce qu'un pixel prédéterminé (16) dans la zone d'occultation optique (15) est prévu pour générer un signal de référence de position de pixel devant être fourni en conjonction avec le signal vidéo, présentant un niveau différent de ceux des signaux de sortie des autres pixels de la zone d'occultation optique (15).

2. Dispositif d'imagerie à couplage de charge à semi-conducteur selon la revendication 1, dans lequel ledit moyen d'occultation de la lumière (34) comprend une ouverture sur une position correspondant audit pixel prédéterminé (16) dans la zone d'occultation optique (15).

3. Dispositif d'imagerie à couplage de charge à semi-conducteur selon la revendication 1, dans lequel un moyen d'émission de lumière est positionné entre ledit moyen d'occultation de la lumière et lesdits pixels et est prévu pour éclairer ledit pixel prédéterminé (16) avec une lumière dans la zone d'occultation optique (15).

4. Dispositif d'imagerie à couplage de charge à semi-conducteur selon la revendication 1, dans lequel l'amplitude d'un courant d'occultation produit par ledit pixel prédéterminé (16) dans la zone d'occultation optique (15) est prise plus grande que l'amplitude des courants d'occultation produits par les autres pixels de la zone d'occultation optique en autorisant un état de surface d'appauvrissement de la partie de capteur (21) pour seulement ledit pixel prédéterminé.
